# EUROPEAN PATENT SPECIFICATION

(11) **EP 2 257 994 B1**
(45) Date of publication and mention of the grant of the patent: **17.01.2018**
(21) Application number: 09755477.8
(22) Date of filing: 03.04.2009
(51) Int. Cl.: H01L 31/048, B32B 17/10, B32B 37/10

(54) **SOLAR CELL MODULES COMPRISING HIGH MELT FLOW POLY(VINYL BUTYRAL) ENCAPSULANTS**
SOLARZELLENMODULE MIT POLY(VINYLBUTYRAL) -VERKAPSELUNGSSTOFF MIT HOHEM SCHMELZFLUSS
MODULES DE CELLULE SOLAIRE COMPRENANT DES ENCAPSULANTS EN POLY(VINYL BUTYRAL) À HAUT INDICE DE FLUAGE

(30) Priority: 04.04.2008 US 123126
(43) Date of publication of application: 08.12.2010
(73) Proprietor: Kuraray America Inc., Houston, TX 77058 (US)
(72) Inventor: HAYES, Richard, Allen, Beaumont, TX 77706 (US); SMITH, Rebecca, L., Vienna, WV 26105 (US); PROOST, Kristof, 2620 Hemiksem (BE)
(74) Representative: Morf, Jan Stefan
(86) International application number: PCT/US2009/039381
(87) International publication number: WO 2009/146115

(56) References cited:
- WO-A1-03/006240
- US-A- 3 957 537
- US-A- 4 321 418
- US-A1- 2005 284 516
- RAHMAN M ET AL: "The plasticizer market: an assessment of traditional plasticizers and research trends to meet new challenges" PROGRESS IN POLYMER SCIENCE, PERGAMON PRESS, OXFORD, GB LNKD- DOI:10.1016/J.PROGPOLYMSCI.2004.10.001, vol. 29, no. 12, 1 December 2004 (2004-12-01), pages 1223-1248, XP004638225 ISSN: 0079-6700

## Description

### FIELD OF THE INVENTION

The present invention relates to solar cell modules comprising poly(vinyl butyral) encapsulants with high melt flow rate and methods for producing the same.

### BACKGROUND OF THE INVENTION

Because they provide a sustainable energy resource, the use of solar cells is rapidly expanding. Solar cells can typically be categorized into two types based on the light absorbing material used, i.e., bulk or wafer-based solar cells and thin film solar cells.

Monocrystalline silicon (c-Si), poly- or multi-crystalline silicon (poly-Si or mc-Si) and ribbon silicon are the materials used most commonly in forming the more traditional wafer-based solar cells. Solar cell modules derived from wafer-based solar cells often comprise a series of 180 and 240 µm thick self-supporting wafers (or cells) that are soldered together. Such a panel of solar cells is called a solar cell layer and it may further comprise electrical wirings such as cross ribbons connecting the individual cell units and bus bars having one end connecting to the cells and the other exiting the module. These electrical wirings may be up to 200 µm thick and 10 mm wide. The solar cell layer is then further laminated to encapsulant layer(s) and protective layer(s) to form a weather resistant module that may be used for up to 25 to 30 years. In general, a solar cell module derived from wafer-based solar cell(s) comprises, in order of position from the top light-receiving side to the back non-light-receiving side: (1) an incident layer, (2) a front encapsulant layer, (3) a solar cell layer, (4) a back encapsulant layer, and (5) a backing layer.

As for the increasingly important alternative thin film solar cells, the commonly used materials include amorphous silicon (a-Si), microcrystalline silicon (µc-Si), cadmium telluride (CdTe), copper indium selenide (CuInSe₂ or CIS), copper indium/gallium diselenide (CuInxGa₍₁₋ₓ₎Se₂ or CIGS), light absorbing dyes, and organic semiconductors. By way of example, thin film solar cells are disclosed in e.g., U.S. Patent Nos. 5,507,881; 5,512,107; 5,948,176; 5,994,163; 6,040,521; 6,137,048; and 6,258,620 and U.S. Patent Publication Nos. 20070298590; 20070281090; 20070240759; 20070232057; 20070238285; 20070227578; 20070209699; and 20070079866. Thin film solar cells with a typical thickness of less than 2 µm are produced by depositing layers of the semiconductor material onto a superstrate or substrate formed of glass or a flexible film. As with wafer cells, the solar cell layer may further comprise electrical wirings such as cross ribbons and bus bars. In certain embodiments, a laser scribing sequence is included during the manufacture of thin film solar cells, which enables the adjacent cells to be directly interconnected in series, with no need for further solder connections between cells. In such embodiments, the solar cell layer may further comprise bus bars and connection lines leading the electric power out of the module. And similarly to wafer cells, the thin film solar cells are further laminated to other encapsulant and protective layers to produce a weather resistant and environmentally robust module. However, depending on the sequence in which the multi-layer deposition is carried out, the cells may be deposited on a superstrate that ultimately serves as the incident layer in the final module, or the cells may be deposited on a substrate that serves as the backing layer in the final module. Therefore, a solar cell module derived from thin film solar cells may have one of two types of construction. The first type includes, in order of position from the top light-receiving side to the back non-light-receiving side, (1) a solar cell layer comprising a superstrate and a layer of thin film solar cell(s) deposited thereon at the non-light-receiving side, (2) a (back) encapsulant layer, and (3) a backing layer. The other type may include, in order of position from the top light-receiving side to the back non-light-receiving side, (1) an incident layer, (2) a (front) encapsulant layer, and (3) a solar cell layer comprising a layer of thin film solar cell(s) deposited on a substrate at the light-receiving side thereof.

The encapsulant layers used in solar cell modules are designed to encapsulate and protect the fragile solar cells. Suitable polymeric materials used in the solar cell encapsulant layers typically possess a combination of characteristics such as high transparency, low haze, high impact resistance, high penetration resistance, good ultraviolet (UV) light resistance, good long term thermal stability, adequate adhesion strength to glass and other rigid polymeric sheets, high moisture resistance, and good long term weatherability. In addition, the optical properties of the front encapsulant layer may be such that light can be effectively transmitted to the solar cell layer.

Plasticized poly(vinyl butyral) compositions have been disclosed as materials for solar cell encapsulant layers. See, e.g., U.S. Patent Nos. 3,957,537; 4,249,958; 4,321,418; 5,508,205; US 5,582,653; 5,728,230; 6,075,202; 6,288,323; 6,288,326; 6,538,192; 6,777,610; 6,822,157; and 6,940,008, U.S. Patent Publication Nos. 20040191422 and 20050284516, and European Patent Nos. EP 0 343 628; EP 0 631 328; EP 1 005 096; and EP 1 054 456. In these applications, the plasticized poly(vinyl butyral) compositions are used for the most part as hot melt adhesives to encapsulate and protect the solar cells.

To prolong the useful life of a solar cell module and prevent de-lamination, it is important to have sufficient deaeration between the component layers, especially between the encapsulants and the solar cell layers, during the lamination process. For example, to achieve sufficient deaeration, it would be advantageous if the encapsulant material could flow easily around the cells and fill in the voids between the individual wafer-based solar cells. As for thin film solar cells, because of the presence of the electrical wirings, such as the cross ribbons and bus bars (150 to 250 µm thick), which are much thicker in comparison to the cells (less than 2 µm thick), it is even more important for the encapsulant material to flow easily around the wirings in order to provide sufficient deaeration between the encapsulants and the solar cell layers. Additionally, in order to function as effective protective layers for the solar cells, the encapsulants should not creep or flow under typical operating conditions. The plasticized poly(vinyl butyral) encapsulants currently used are not optimized to meet these requirements.

### SUMMARY OF THE INVENTION

The invention provides a solar cell module comprising a solar cell layer and a poly(vinyl butyral) sheet, wherein (a) the solar cell layer comprises one or a plurality of electrically interconnected solar cells; (b) the solar cell layer has a light-receiving side and a non-light-receiving side; (c) the poly(vinyl butyral) sheet has a melt flow rate (MFR) of 0.8 to 2 g/10 min as determined according to ASTM 1238 (150°C, 5 kg load, 2 mm orifice) and comprises a poly(vinyl butyral) resin and a plasticizer; and (d) the poly(vinyl butyral) sheet is laminated to one of the two sides of the solar cell layer.

In one embodiment, the poly(vinyl butyral) sheet has a MFR of 1 to 1.7 g/10 min.

In a further embodiment, the poly(vinyl butyral) sheet has a MFR of 1.1 to 1.3 g/10 min.

In a yet further embodiment, the poly(vinyl butyral) sheet has a thickness of 0.25 to 1.52 mm.

In a yet further embodiment, the poly(vinyl butyral) sheet has a thickness of 0.38 to 1.14 mm.

In a yet further embodiment, the poly(vinyl butyral) resin has a weight average molecular weight of 30,000 to 600,000 and contains 12 to 23 wt% of hydroxyl groups calculated as polyvinyl alcohol (PVOH).

In a yet further embodiment, the poly(vinyl butyral) resin has a weight average molecular weight of 200,000 to 300,000 and contains 15 to 19 wt% of hydroxyl groups calculated as polyvinyl alcohol (PVOH).

In a yet further embodiment, the poly(vinyl butyral) sheet comprises 5 to 80 parts per hundred (pph) of the plasticizer based on the dry weight of the poly(vinyl butyral) resin.

In a yet further embodiment, the poly(vinyl butyral) sheet comprises 30 to 40 parts per hundred (pph) of the plasticizer based on the dry weight of the poly(vinyl butyral) resin and wherein the plasticizer is selected from the group consisting of triethylene glycol di-2-ethylhexanoate, tetraethylene glycol di-n-heptanoate, dibutyl sebacate, and mixtures of two or more thereof.

In a yet further embodiment, the poly(vinyl butyral) sheet is directly laminated to the solar cell layer.

In a yet further embodiment, the module comprises a front encapsulant layer laminated to the light-receiving side of the solar cell layer and a back encapsulant layer laminated to the non-light-receiving side of the solar cell layer, wherein one of the front and back encapsulant layers is the poly(vinyl butyral) sheet described above and the other of the front and back encapsulant layers comprises a polymeric material selected from the group consisting of acid copolymers, ionomers, poly(ethylene vinyl acetates), poly(vinyl acetals), polyurethanes, polyvinylchlorides, polyethylenes, polyolefin block copolymer elastomers, poly(α-olefin-co-α,β-ethylenically unsaturated carboxylic acid ester) copolymers, silicone elastomers, epoxy resins, and combinations thereof.

In a yet further embodiment, the module comprises two of the poly(vinyl butyral) sheets described above, wherein each of the front and back encapsulant layers is one of the two poly(vinyl butyral) sheets.

In a yet further embodiment, the module further comprises an incident layer and/or a backing layer, wherein the incident layer is an outermost surface layer of the module and is positioned on the light-receiving side of the solar cell layer, and wherein the backing layer is an outermost surface layer of the module and is positioned on the non-light receiving side of the solar cell layer.

In a yet further embodiment, the incident layer is selected from the group consisting of (i) glass sheets, (ii) polymeric sheets comprising or made of polycarbonates, acrylics, polyacrylates, cyclic polyolefins, polystyrenes, polyamides, polyesters, fluoropolymers, or combinations of two or more thereof, and (iii) polymeric films comprising or made of polyesters, polycarbonate, polyolefins, norbornene polymers, polystyrene, styrene-acrylate copolymers, acrylonitrile-styrene copolymers, polysulfones, nylons, polyurethanes, acrylics, cellulose acetates, cellophane, poly(vinyl chlorides), fluoropolymers, or combinations of two or more thereof, and wherein the backing layer is selected from the group consisting of (iv) glass sheets, (v) polymeric sheets, (vi) polymeric films, (vii) metal sheets, and (viii) ceramic plates, and wherein the polymeric sheets comprise or are made of polycarbonates, acrylics, polyacrylates, cyclic polyolefins, polystyrenes, polyamides, polyesters, fluoropolymers, or combinations or two or more thereof; and the polymeric films comprise or are made of polyesters, polycarbonates, polyolefins, norbornene polymers, polystyrenes, styrene-acrylate copolymers, acrylonitrile-styrene copolymers, polysulfones, nylons, polyurethanes, acrylics, cellulose acetates, cellophanes, poly(vinyl chlorides), fluoropolymers, or combinations of two or more thereof.

In a yet further embodiment, the solar cells are wafer-based solar cells selected from the group consisting of crystalline silicon (c-Si) and multi-crystalline silicone (mc-Si) based solar cells. Such a module may consists essentially of, in order of position, (i) an incident layer, (ii) a front encapsulant layer laminated to the light-receiving side of the solar cell layer, (iii) the solar cell layer, (iv) a back encapsulant layer laminated to the non-light receiving side of the solar cell layer, and (v) a backing layer, wherein one of the front and back encapsulant layers is the poly(vinyl butyral) sheet described above. Alternatively, such a module may comprise two of the poly(vinyl butyral) sheets described above, wherein each of the front and back encapsulant layers comprises one of the two poly(vinyl butyral) sheets.

In a yet further embodiment, the solar cells are thin film solar cells selected from the group consisting of amorphous silicon (a-Si), microcrystalline silicon (µc-Si), cadmium telluride (CdTe), copper indium selenide (CIS), copper indium/gallium diselenide (CIGS), light absorbing dyes, and organic semiconductors based solar cells. Such a module may consist essentially of, in order of position , (i) an incident layer, (ii) a front encapsulant layer comprising the poly(viny butyral) sheet described above, and (iii) the solar cell layer, wherein the solar cell layer further comprises a substrate upon which the thin film solar cells are deposited and the substrate is positioned such that the substrate is an outermost surface of the module and is positioned on the non-light-receiving side of the solar cell layer. Alternatively, the module consists essentially of, in order of position (i) the solar cell layer, (ii) a back encapsulant layer comprising the poly(vinyl butyral) sheet described above, and (iii) a backing layer, wherein the solar cell layer further comprises a superstrate upon which the thin film solar cells are deposited and the superstrate is positioned such that the superstrate is an outermost surface of the module on the light-receiving side of the solar cell layer.

The invention further provides a process for preparing a solar cell module, comprising: (i) providing an assembly comprising all the component layers described in the above solar cell modules and (ii) laminating the assembly to form the solar cell module. In one embodiment, the laminating step is conducted by subjecting the assembly to heat and optionally vacuum or pressure.

### BRIEF DESCRIPTION OF THE DRAWINGS

Figure 1 is a not-to-scale cross-sectional view of a wafer-based solar cell module disclosed herein.
Figure 2 is a not-to-scale cross-sectional view of one particular thin film solar cell module disclosed herein.
Figure 3 is a not-to-scale cross-sectional view of another thin film solar cell module disclosed herein.

### DETAILED DESCRIPTION OF THE INVENTION

Unless otherwise defined, all technical and scientific terms used herein have the same meaning as commonly understood by one of ordinary skill in the art to which this invention belongs. In case of conflict, the specification, including definitions, will control.

Although methods and materials similar or equivalent to those described herein can be used in the practice or testing of the invention, suitable methods and materials are described herein.

Unless stated otherwise, all percentages, parts, ratios, etc., are by weight.

When an amount, concentration, or other value or parameter is given as either a range, preferred range or a list of upper preferable values and lower preferable values, this is to be understood as specifically disclosing all ranges formed from any pair of any upper range limit or preferred value and any lower range limit or preferred value, regardless of whether ranges are separately disclosed. Where a range of numerical values is recited herein, unless otherwise stated, the range is intended to include the endpoints thereof, and all integers and fractions within the range. It is not intended that the scope of the invention be limited to the specific values recited when defining a range.

When the term "about" is used in describing a value or an end-point of a range, the disclosure should be understood to include the specific value or end-point referred to.

As used herein, the terms "comprises," "comprising," "includes," "including," "containing," "characterized by," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or.

The transitional phrase "consisting essentially of" limits the scope of a claim to the specified materials or steps and those that do not materially affect the basic and novel characteristic(s) of the claimed invention.

Where applicants have defined an invention or a portion thereof with an openended term such as "comprising," it should be readily understood that (unless otherwise stated) the description should be interpreted to also describe such an invention using the term "consisting essentially of".

Use of "a" or "an" are employed to describe elements and components of the invention. This is merely for convenience and to give a general sense of the invention. This description should be read to include one or at least one and the singular also includes the plural unless it is obvious that it is meant otherwise.

In describing certain polymers it should be understood that sometimes applicants are referring to the polymers by the monomers used to make them or the amounts of the monomers used to make them. While such a description may not include the specific nomenclature used to describe the final polymer or may not contain product-by-process terminology, any such reference to monomers and amounts should be interpreted to mean that the polymer is made from those monomers or that amount of the monomers, and the corresponding polymers and compositions thereof.

In describing and/or claiming this invention, the term "copolymer" is used to refer to polymers containing copolymerized units of two or more monomers.

The terms "finite amount" and "finite value" are used to refer to an amount that is greater than zero.

For the purpose of the present application, the terms "poly(vinyl butyral) composition", "poly(vinyl butyral) resin composition", and "plasticized poly(vinyl butyral) composition" are used interchangeably to refer to a composition comprising a finite amount of poly(vinyl butyral) and a finite amount of plasticizer. In addition, the poly(vinyl butyral) composition as defined above may contain a single plasticizer or a mixture of plasticizers. For convenience, however, when describing a poly(vinyl butyral) composition, a mixture of plasticizers can also be referred to as "plasticizer". That is, the singular form of the word "plasticizer" as used herein may represent the use of either one plasticizer or a mixture of two or more plasticizers.

The terms "plasticized poly(vinyl butyral) sheet" and "poly(vinyl butyral) sheet" are used interchangeably to refer to a polymeric sheet comprising the poly(vinyl butyral) composition as defined above.

The invention provides solar cell encapsulant sheets comprising or made of certain high melt flow poly(vinyl butyral) sheets having a melt flow rate (MFR) of 0.8 to 2 g/10 min as determined in accordance with ASTM 1238 (150°C, 5 kg load, 2 mm orifice). Preferably, the high melt flow poly(vinyl butyral) sheets have a MFR of 0.9 to 1.8 g/10 min or more preferably 1 to 1.7 g/10 min or yet more preferably 1.1 to 1.3 g/10 min, as determined in accordance with ASTM 1238 (150°C, 5 kg load, 2 mm orifice). It will be understood by those skilled in the art that in the case of the present invention a polymer sheet and the total polymer composition comprised in the polymer sheet material will have the same MFR. Therefore, the values of MFR disclosed herein characterize both the poly(vinyl butyral) sheet and the total poly(vinyl butyral) composition comprised in the sheet material.

Poly(vinyl butyral) is a vinyl resin resulting from the condensation of poly(vinyl alcohol) with butyraldehyde. The poly(vinyl butyral) may be produced by aqueous or solvent acetalization. In a solvent process, acetalization is carried out in the presence of sufficient solvent to dissolve the poly(vinyl butyral) and produce a homogeneous solution at the end of acetalization. The poly(vinyl butyral) is separated from solution by precipitation of solid particles with water, which are then washed and dried. Solvents used are lower aliphatic alcohols such as ethanol. In an aqueous process, acetalization is carried out by adding butyraldehyde to a water solution of poly(vinyl alcohol) at a temperature of about 20°C to about 100°C, in the presence of an acid catalyst, agitating the mixture to cause an intermediate poly(vinyl butyral) to precipitate in finely divided form and continuing the agitation while heating until the reaction mixture has proceeded to the desired end point, followed by neutralization of the catalyst, separation, stabilization and drying of the poly(vinyl butyral). For example, poly(vinyl butyral) can be produced as disclosed in US 3,153,009 and US 4,696,971.

The poly(vinyl butyral) resins comprised in the high melt flow poly(vinyl butyral) sheets may have a weight average molecular weight of 30,000 to 600,000, preferably 45,000 to 300,000, or more preferably 200,000 to 300,000, as determined by size exclusion chromatography using low angle laser light scattering. The poly(vinyl butyral) may comprise 12 to 23 wt%, preferably 14 to 21 wt%, more preferably 15 to 19.5 wt%, or most preferably 15 to 19 wt% of hydroxyl groups calculated as polyvinyl alcohol (PVOH). The hydroxyl number can be determined according to standard methods, such as ASTM D1396-92 (1998). In addition, preferred poly(vinyl butyral) may include up to 10%, or more preferably up to 3% of residual ester groups, calculated as polyvinyl ester, typically acetate groups, with the balance being butyraldehyde acetal. The poly(vinyl butyral) may further comprise a minor amount of acetal groups other than butyral, for example, 2-ethyl hexanal, as disclosed in U.S. Patent No. 5,137,954.

In addition to the poly(vinyl butyral), the high melt flow poly(vinyl butyral) sheets of the invention also contain 15 to 80 parts per hundred (pph) of plasticizer, based on the poly(vinyl butyral) resin weight. Preferably, 25 to 45 pph, more preferably 30 to 40 pph, or most preferably 33 to 38 pph of plasticizer, based on the poly(vinyl butyral) resin weight, is included in the sheet composition. The plasticizer improves the flexibility and processability for the poly(vinyl butyral) sheets. Plasticizers suitable for poly(vinyl butyral) compositions are known within the art (see, e.g., U.S. Patent Nos. 3,841,890; 4,144,217; 4,276,351; 4,335,036; 4,902,464; 5,013,779; and 5,886,075). Among those commonly used plasticizers are esters of a polybasic acid or a polyhydric alcohol. Preferred plasticizers include, but are not limited to, diesters obtained from the reaction of triethylene glycol or tetraethylene glycol with aliphatic carboxylic acids having from 6 to 10 carbon atoms; diesters obtained from the reaction of sebacic acid with aliphatic alcohols having from 1 to 18 carbon atoms; oligoethylene glycol di-2-ethylhexanoate; tetraethylene glycol di-n-heptanoate; dihexyl adipate; dioctyl adipate; mixtures of heptyl and nonyl adipates; dibutyl sebacate; tributoxyethylphosphate; isodecylphenylphosphate; triisopropylphosphite; polymeric plasticizers, such as the oil-modified sebacid alkyds; mixtures of phosphates and adipates; mixtures of adipates and alkyl benzyl phthalates; and mixtures thereof. More preferred plasticizers include triethylene glycol di-2-ethylhexanoate, tetraethylene glycol di-n-heptanoate, dibutyl sebacate, and mixtures thereof. Yet more preferred plasticizers include triethylene glycol di-2-ethylhexanoate, tetraethylene glycol di-n-heptanoate, and mixtures thereof. The most preferred the plasticizer is triethylene glycol di-2-ethylhexanoate.

In general, to obtain a poly(vinyl butyral) sheet with a certain MFR, the procedure often involves (a) adjusting the molecular weight or MFR of the poly(vinyl alcohol) used in making the un-plasticized poly(vinyl butyral) resin and/or (b) adjusting the level of plasticizer contained in the poly(vinyl butyral) sheet composition. Specifically, un-plasticized poly(vinyl butyral) resins derived from poly(vinyl alcohols) with lower molecular weight or higher MFR also tend to have a lower molecular weight or higher MFR and, when combined with plasticizers, give rise to plasticized poly(vinyl butyral) sheets with higher MFR. On the other hand, the higher the level of plasticizer contained in a poly(vinyl butyral) sheet, the higher the MFR of the sheet. It is within the ability of any skilled artisan to produce the above-described high melt flow plasticized poly(vinyl butyral) sheet by adjusting the molecular weight or MFR of the un-plasticized the poly(vinyl butyral) resin comprised therein and/or the level of plasticizer comprised therein. Preferably, the MFR of the abovedescribed high melt flow poly(vinyl butyral) sheet is achieved by adjusting the molecular weight or MFR of the un-plasticized poly(vinyl butyral) resin. More preferably, the MFR of the above described high melt flow poly(vinyl butyral) sheet is achieved by adjusting the molecular weight or MFR of the un-plasticized poly(vinyl butyral) resin while maintaining the most preferred plasticizer levels specified above.

The lower limit of MFR for the high melt flow poly(vinyl butyral) sheet was determined to allow the sheet material to sufficiently flow around and fully encapsulate the solar cell(s) and the electrical wirings (e.g., the cross ribbons and bus bars) during the lamination process. Poly(vinyl butyral) encapsulant sheets currently used in the art which have lower MFR do not have sufficient flow under lamination conditions. Attempts to overcome such deficiency typically include (i) applying increased pressure during the lamination process, which oftentimes results in broken or cracked incident layers, backing layers, and/or solar cell(s) and/or (ii) increasing the thickness of the poly(vinyl butyral) encapsulant sheets, which results in undesirable thicker and heavier solar cell modules.

The upper limit of MFR for the high melt flow poly(vinyl butyral) sheet was determined to provide sufficient protection to the fragile solar cell(s) and prevent the sheet material from creeping outside the edges of the solar cell module during the lamination process or over the course of the 20-30 year intended lifetime of the solar cell module.

An adhesion control additive for, e.g., controlling the adhesive bond between the high melt flow poly(vinyl butyral) sheets and other component layers in the solar cell modules, may also be included in the sheet composition. Such additives are generally alkali metal or alkaline earth metal salts of organic and inorganic acids. Preferably, they are alkali metal or alkaline earth metal salts of organic carboxylic acids having from 2 to 16 carbon atoms. More preferably, they are magnesium or potassium salts of organic carboxylic acids having from 2 to 16 carbon atoms. Specific examples of the adhesion control additives include, e.g., potassium acetate, potassium formate, potassium propanoate, potassium butanoate, potassium pentanoate, potassium hexanoate, potassium 2-ethylbutylate, potassium heptanoate, potassium octanoate, potassium 2-ethylhexanoate, magnesium acetate, magnesium formate, magnesium propanoate, magnesium butanoate, magnesium pentanoate, magnesium hexanoate, magnesium 2-ethylbutylate, magnesium heptanoate, magnesium octanoate, magnesium 2-ethylhexanoate and the like and mixtures thereof. The adhesion control additive is typically used in the range of 0.001 to 0.5 wt%, based on the total weight of the composition.

Surface tension controlling agents, such as Trans® 290 or Trans® 296 (Trans-Chemco Company, Bristol, WI) or Q-23183® (The Dow Chemical Company, Midland, MI) can also be contained in the poly(vinyl butyral) sheet compositions.

The high melt flow poly(vinyl butyral) sheets may also contain other additives known within the art. The additives may include, but are not limited to, processing aids, flow enhancing additives, lubricants, pigments, dyes, flame retardants, impact modifiers, nucleating agents, anti-blocking agents such as silica, thermal stabilizers, UV absorbers, UV stabilizers, dispersants, surfactants, chelating agents, coupling agents, reinforcement additives, such as glass fiber, fillers and the like. Generally, additives that may reduce the optical clarity of the composition, such as reinforcement additives and fillers, are reserved for those sheets that are used as the back encapsulants.

Thermal stabilizers can be used and have been widely disclosed within the art. Any known thermal stabilizer may find utility within the invention. Preferable general classes of thermal stabilizers include, but are not limited to, phenolic antioxidants, alkylated monophenols, alkylthiomethylphenols, hydroquinones, alkylated hydroquinones, tocopherols, hydroxylated thiodiphenyl ethers, alkylidenebisphenols, O-, N- and S-benzyl compounds, hydroxybenzylated malonates, aromatic hydroxybenzyl compounds, triazine compounds, aminic antioxidants, aryl amines, diaryl amines, polyaryl amines, acylaminophenols, oxamides, metal deactivators, phosphites, phosphonites, benzylphosphonates, ascorbic acid (vitamin C), compounds that destroy peroxide, hydroxylamines, nitrones, thiosynergists, benzofuranones, indolinones, and the like and mixtures thereof. More preferably, the thermal stabilizer is a bis-phenolic antioxidant. Such compositions have been found to be surprisingly suitable for preparing plasticized poly(vinyl butyral), especially when used in combination with the triethylene glycol di-2-ethylhexanoate plasticizer. Suitable specific bis-phenolic antioxidants include 2,2'-ethylidenebis(4,6-di-t-butylphenol); 4,4'-butylidenebis(2-t-butyl-5-methylphenol); 2,2'-isobutylidenebis(6-t-butyl-4-methylphenol); and 2,2'-methylenebis(6-t-butyl-4-methylphenol). Bis-phenolic antioxidants are commercially available under the tradenames of Anox® 29 and Lowinox® 22M46, 44B25, and 22IB46 (Great Lakes Chemical Corporation, Indianapolis, IN). The high melt flow poly(vinyl butyral) sheets may contain any effective amount of thermal stabilizers. Use of a thermal stabilizer is optional and in some instances is not preferred. When used, the poly(vinyl butyral) sheets contain at least 0.05 wt%, and up to 10 wt%, more preferably up to 5 wt%, and most preferably up to 1 wt%, of thermal stabilizers, based on the total weight of the sheet composition.

UV absorbers can be used and have also been widely disclosed within the art. Any known UV absorber may find utility within the present invention. Preferable general classes of UV absorbers include, but are not limited to, benzotriazole derivatives, hydroxybenzophenones, hydroxyphenyl triazines, esters of substituted and unsubstituted benzoic acids, and the like and mixtures thereof. The high melt flow poly(vinyl butyral) sheets may contain any effective amount of UV absorbers. Use of a UV absorber is optional and in some instances is not preferred. When used, the poly(vinyl butyral) sheets contain at least 0.05 wt%, and up to 10 wt%, more preferably up to 5 wt%, and most preferably up to 1 wt%, of UV absorbers, based on the total weight of the sheet composition.

Hindered amine light stabilizers (HALS) can be used and have also been widely disclosed within the art. Generally, hindered amine light stabilizers are disclosed to be secondary, tertiary, acetylated, N-hydrocarbyloxy substituted, hydroxy substituted N-hydrocarbyloxy substituted, or other substituted cyclic amines which further incorporate steric hindrance, generally derived from aliphatic substitution on the carbon atoms adjacent to the amine function. The high melt flow poly(vinyl butyral) sheets may contain any effective amount of hindered amine light stabilizers. Use of hindered amine light stabilizers is optional and in some instances is not preferred. When used, the poly(vinyl butyral) sheets contain at least 0.05 wt%, and up to 10 wt%, more preferably up to 5 wt%, and most preferably,up to 1 wt%, of hindered amine light stabilizers, based on the total weight of the sheet composition.

The high melt flow poly(vinyl butyral) sheets may be produced through any known process. Generally, the poly(vinyl butyral) sheets are produced through extrusion casting processes. The sheets may have smooth or rough surfaces. Preferably, the poly(vinyl butyral) sheets have rough surfaces to facilitate deaeration during the lamination process.

For example, the high melt flow poly(vinyl butyral) sheets may be produced by initially mixing the poly(vinyl butyral) with an appropriate amount of plasticizer and then extruding the composition through a sheet-shaping die, i.e. forcing the molten plasticized poly(vinyl butyral) composition through a horizontally long, vertically narrow die opening substantially conforming in length and width to that of the sheet being formed. The plasticized poly(vinyl butyral) compositions can generally be extruded at a temperature of 225°C to 245°C. Rough surfaces on one or both sides of the extruding sheet are preferably provided by the design of the die opening and the temperature of the die exit surfaces through which the extrudate passes, as disclosed in, e.g., U.S. Patent No. 4,281,980. Alternative techniques for producing a preferable rough surface on an extruding poly(vinyl butyral) sheet involve the specification and control of one or more of polymer molecular weight distribution, water content and melt temperature. Sheet formations of plasticized poly(vinyl butyral) is disclosed, e.g., in U.S. Patent Nos. 2,904,844; 2,909,810; 3,679,788; 3,994,654; 4,161,565; 4,230,771; 4,292,372; 4,297,262; 4,575,540; 5,151,234; and 5,886,675 and European Patent No. EP 0 185 863. Alternatively, the as extruded poly(vinyl butyral) sheets may be passed over a specially prepared surface of a die roll positioned in close proximity to the exit of the die which imparts the desired preferable surface characteristics to one side of the molten polymer. Thus, when the surface of such roll has minute peaks and valleys, sheets formed of polymers cast thereon will have a rough surface on the side which contacts the roll which generally conforms respectively to the valleys and peaks of the roll surface. Such die rolls are disclosed in, e.g., U.S. Patent No. 4,035,549. A rough sheet surface is preferred to simplify the lamination process and to provide superior solar cell modules. It is understood that such rough surface is only temporary and particularly functions to facilitate deaeration during lamination, after which it is melted smooth from the elevated temperature and pressure associated with autoclaving and other lamination processes.

The thickness of the high melt flow poly(vinyl butyral) sheets may be 10 to 60 mil (0.25 to 1.52 mm). Preferably, the thickness of the high melt flow poly(vinyl butyral) sheet is 15 to 45 mil (0.38 to 1.14 mm), more preferably 15 to 40 mil (0.38 to 1.02 mm), yet more preferably 15 to 35 mil (0.38 to 0.89 mm), and yet more preferably 20 to 35 mil (0.51 to 0.89 mm), to provide adequate protection to the solar cell while minimizing the amount of encapsulant utilized. The minimization of thickness will improve the clarity and light transmission of the sheet and, in turn, enhance efficiency of the solar cell module comprising the same. It may further desirably reduce the thickness and weight of the final solar cell module. On the other hand, the high melt flow poly(vinyl butyral) sheets need also to have sufficient thickness to flow around and encapsulate the solar cells and the wirings such as the cross ribbons and bus bars.

The invention further provides a solar cell module comprising at least one layer of the above described high melt flow poly(vinyl butyral) sheet and a solar cell layer comprised of one or a plurality of solar cells. Preferably, the solar cells are electrically interconnected and/or arranged in a flat plane.

The term "solar cell" is meant to include any article which can convert light into electrical energy. Solar cells useful in the invention include, but are not limited to, wafer-based solar cells (e.g., c-Si or mc-Si based solar cells, as described above in the background section) and thin film solar cells (e.g., a-Si, µc-Si, CdTe, or CI(G)S based solar cells, as described above in the background section). Within the solar cell layer, it is preferred that the solar cells are electrically interconnected. In addition, the solar cell layer may further comprise electrical wirings, such as cross ribbons and bus bars.

The solar cell module typically comprises at least one layer of the high melt flow poly(vinyl butyral) sheet that is laminated to the solar cell layer and serves as an encapsulant layer. By "laminated", it is meant that, within a laminated structure, the two layers are bonded either directly (i.e., without any additional material between the two layers) or indirectly (i.e., with additional material, such as interlayer or adhesive materials, between the two layers). Preferably, the high melt flow poly(vinyl butyral) sheet is directly laminated or bonded to the solar cell layer.

The solar cell module may further comprise additional encapsulant layers comprising or made of other polymeric materials, such as acid copolymers (i.e., copolymers of α-olefins and α,β-ethylenically unsaturated carboxylic acids), ionomers (i.e., copolymers produced by partially or fully neutralizing acid copolymers of α-olefins and α,β-ethylenically unsaturated carboxylic acids), poly(ethylene vinyl acetates), poly(vinyl acetals) (including acoustic grade poly(vinyl acetals)), polyurethanes, poly(vinyl chlorides), polyethylenes (e.g., linear low density polyethylenes), polyolefin block copolymer elastomers, poly(α-olefin-co-α,β-ethylenically unsaturated carboxylic acid esters) (e.g., poly(ethylene-co-methyl acrylate) and poly(ethylene-co-butyl acrylate)), silicone elastomers, epoxy resins, and combinations of two or more thereof.

The thickness of the individual encapsulant layers other than the high melt flow poly(vinyl butyral) sheet(s) may independently be 1 to 120 mil (0.026 mm to 3 mm), preferably 1 to 40 mil 0.026 to 1.02 mm), or more preferably 1 to 20 mil (0.026 to 0.51 mm). All the encapsulant layer(s) comprised in the solar cell modules may have smooth or rough surfaces. Preferably, the encapsulant layer(s) have rough surfaces to facilitate the deaeration of the laminates through the lamination process.

The solar cell module may yet further comprise an incident layer and/or a backing layer serving as the outer most layers of the module at the light-receiving side and the non-light-receiving side, respectively.

The outer layers of the solar cell modules, i.e., the incident layer and the backing layer, may be derived from any suitable sheets or films. Suitable sheets may be glass or plastic sheets, such as polycarbonates, acrylics, polyacrylates, cyclic polyolefins (e.g., ethylene norbornene polymers), polystyrenes (preferably metallocene-catalyzed polystyrenes), polyamides, polyesters, fluoropolymers, or combinations of two or more thereof. In addition, metal sheets, such as aluminum, steel, galvanized steel, or ceramic plates may be utilized in forming the backing layer.

The term "glass" includes not only window glass, plate glass, silicate glass, sheet glass, low iron glass, tempered glass, tempered CeO-free glass, and float glass, but also colored glass, specialty glass (such as those containing ingredients to control solar heating), coated glass (such as those sputtered with metals (e.g., silver or indium tin oxide) for solar control purposes), E-glass, Toroglass, Solex® glass (PPG Industries, Pittsburgh, PA) and Starphire® glass (PPG Industries). Such specialty glasses are disclosed in, e.g., U.S. Patent Nos. 4,615,989; 5,173,212; 5,264,286; 6,150,028; 6,340,646; 6,461,736; and 6,468,934. It is understood, however, that the type of glass to be selected for a particular module depends on the intended use.

Suitable film layers may be polymers that include but are not limited to, polyesters (e.g., poly(ethylene terephthalate) and poly(ethylene naphthalate)), polycarbonate, polyolefins (e.g., polypropylene, polyethylene, and cyclic polylolefins), norbornene polymers, polystyrene (e.g., syndiotactic polystyrene), styrene-acrylate copolymers, acrylonitrile-styrene copolymers, polysulfones (e.g., polyethersulfone, polysulfone, etc.), nylons, poly(urethanes), acrylics, cellulose acetates (e.g., cellulose acetate, cellulose triacetates, etc.), cellophane, poly(vinyl chlorides) (e.g., poly(vinylidene chloride)), fluoropolymers (e.g., polyvinyl fluoride, polyvinylidene fluoride, polytetrafluoroethylene, ethylene-tetrafluoroethylene copolymers, etc.) and combinations of two or more thereof. The polymeric film may be bi-axially oriented polyester film (preferably poly(ethylene terephthalate) film) or a fluoropolymer film (e.g., Tedlar®, Tefzel®, and Teflon® films, from E. I. du Pont de Nemours and Company, Wilmington, DE (DuPont)). Fluoropolymer-polyester-fluoropolymer (e.g., "TPT") films are also preferred for some applications. Metal films, such as aluminum foil may also be used as the backing layer.

The solar cell module may further comprise other functional film or sheet layers (e.g., dielectric layers or barrier layers) embedded within the module. Such functional layers may be derived from any of the above mentioned polymeric films or those that are coated with additional functional coatings. For example, poly(ethylene terephthalate) films coated with a metal oxide coating, such as those disclosed within U.S. Patent Nos. 6,521,825 and 6,818,819 and European Patent No. EP1182710, may function as oxygen and moisture barrier layers in the laminates.

If desired, a layer of nonwoven glass fiber (scrim) may also be included between the solar cell layers and the encapsulants to facilitate deaeration during the lamination process or to serve as reinforcement for the encapsulants. The use of such scrim layers is disclosed within, e.g., U.S. Patent Nos. 5,583,057; 6,075,202; 6,204,443; 6,320,115; and 6,323,416 and European Patent No. EP0769818.

The film or sheet layers positioned to the light-receiving side of the solar cell layer are preferably made of transparent material to allow efficient transmission of sunlight into the solar cells. The light-receiving side of the solar cell layer may sometimes be referred to as a top or front side and in actual use conditions would generally face a light source. The non-light-receiving side of the solar cell layer may sometimes be referred to as a lower or back side and in actual use conditions would generally face away from a light source. A special film or sheet may be included to serve both the function of an encapsulant layer and an outer layer. It is also conceivable that any of the film or sheet layers included in the module may be in the form of a pre-formed single-layer or multi-layer film or sheet.

If desired, one or both surfaces of the incident layer films and sheets, the backing layer films and sheets, the encapsulant layers and other layers incorporated within the solar cell module may be treated prior to the lamination process to enhance adhesion to other laminate layers. This adhesion enhancing treatment may take any form known within the art and include flame treatments (see, e.g., U.S. Patent Nos. 2,632,921; 2,648,097; 2,683,894; and 2,704,382), plasma treatments (see e.g., U.S. Patent No. 4,732,814), electron beam treatments, oxidation treatments, corona discharge treatments, chemical treatments, chromic acid treatments, hot air treatments, ozone treatments, ultraviolet light treatments, sand blast treatments, solvent treatments, and combinations of two or more thereof. Also, the adhesion strength may be further improved by further applying an adhesive or primer coating on the surface of the laminate layer(s). For example, U.S. Patent No. 4,865,711 discloses a film or sheet with improved bondability, which has a thin layer of carbon deposited on one or both surfaces. Other exemplary adhesives or primers may include silanes, poly(allyl amine) based primers (see e.g., U.S. Patent Nos. 5,411,845; 5,770,312; 5,690,994; and 5,698,329), and acrylic based primers (see e.g., U.S. Patent No. 5,415,942). The adhesive or primer coating may take the form of a monolayer of the adhesive or primer and have a thickness of 0.0004 to 1 mil (0.00001 to 0.03 mm), or preferably, 0.004 to 0.5 mil (0.0001 to 0.013 mm), or more preferably 0.004 to 0.1 mil (0.0001 to 0.003 mm).

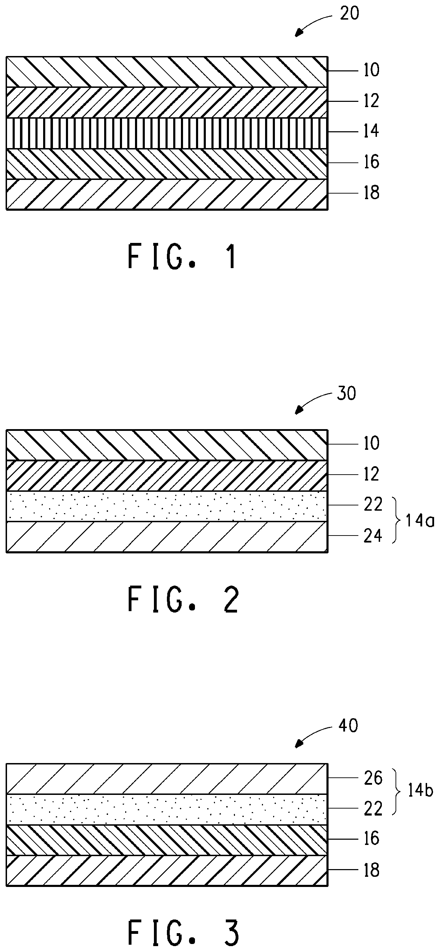

In one particular embodiment (now referring to Figure 1), where the solar cells are derived from wafer-based self supporting solar cell units, the solar cell module (20) may comprise, in order of position from the top light-receiving side to the back non-light-receiving side, (a) an incident layer (10), (b) a front encapsulant layer (12), (c) a solar cell layer (14) comprised of one or more electrically interconnected solar cells, (d) a back encapsulant layer (16), and (e) a backing layer (18), wherein at least one or both of the front and back encapsulant layers (12 and 16) comprise or are made of the high melt flow poly(vinyl butyral) sheets.

Preferably, however, the solar cell modules are derived from thin film solar cells and may (i) in one embodiment (30 in Figure 2), comprise, in order of position from the top light-receiving side to the back non-light-receiving side, (a) a transparent incident layer (10), (b) a (front) encapsulant layer (12) comprising or made of the high melt flow poly(vinyl butyral) sheet, and (c) a solar cell layer (14a) comprising a layer of thin film solar cell(s) (22) deposited on a substrate (24) at the light-receiving side thereof, or (ii) in a more preferred embodiment (40 in Figure 3), comprise, in order of position from the top light-receiving side to the back non-light-receiving side, (a) a solar cell layer (14b) comprising a superstrate (26) and a layer of thin film solar cell(s) (22) deposited thereon at the non-light-receiving side, (b) a (back) encapsulant layer (16) comprising or made of the high melt flow poly(vinyl butyral) sheet, and (c) a backing layer (18).

Moreover, series of the solar cell modules described above may be further linked to form a solar cell array, which can produce a desired voltage and current.

Exemplary solar cell modules may have the following lamination structures, in order of position from the top light-receiving side to the back non-light-receiving side, where HMF-PVB is an abbreviation for a high melt flow poly(vinyl butyral) sheet:
- glass/HMF-PVB/solar cell(s)/HMF-PVB/glass;
- glass/HMF-PVB/solar cell(s)/HMF-PVB/fluoropolymer film (e.g., Tedlar® film);
- fluoropolymer film/HMF-PVB/solar cell(s)/HMF-PVB/glass;
- fluoropolymer film/HMF-PVB/solar cell(s)/HMF-PVB/fluoropolymer film;
- glass/HMF-PVB/solar cell(s)/HMF-PVB/polyester film (e.g., poly(ethylene terephthalate) film);
- fluoropolymer film/HMF-PVB/solar cell(s)/HMF-PVB/polyester film;
- glass/HMF-PVB/solar cell(s)/HMF-PVB/barrier coated film/HMF-PVB/glass;
- glass/ionomer sheet/solar cell(s)/HMF-PVB/barrier coated film/HMF-PVB/fluoropolymer film;
- fluoropolymer film/HMF-PVB/barrier coated film/HMF-PVB/solar cell(s)/HMF-PVB/barrier coated film/HMF-PVB/fluoropolymer film;
- glass/HMF-PVB/solar cell(s)/HMF-PVB/aluminum stock;
- fluoropolymer film/HMF-PVB/solar cell(s)/HMF-PVB/aluminum stock;
- glass/HMF-PVB/solar cell(s)/HMF-PVB/galvanized steel sheet;
- glass/HMF-PVB/solar cell(s)/HMF-PVB/polyester film/HMF-PVB/aluminum stock;
- fluoropolymer film/HMF-PVB/solar cell(s)/HMF-PVB/polyester film/HMF-PVB/aluminum stock;
- glass/HMF-PVB/solar cell(s)/HMF-PVB/polyester film/HMF-PVB/galvanized steel sheet;
- fluoropolymer film /HMF-PVB/solar cell(s)/HMF-PVB/polyester film/HMF-PVB/galvanized steel sheet;
- glass/HMF-PVB/solar cell(s)/acoustic poly(vinyl butyral) sheet/glass;
- glass/HMF-PVB/solar cell(s)/poly(vinyl butyral) sheet/ fluoropolymer film;
- fluoropolymer film/ionomer sheet/solar cell(s)/HMF-PVB/glass;
- fluoropolymer film/HMF-PVB/solar cell(s)/acid copolymer sheet/ fluoropolymer film;
- glass/HMF-PVB/solar cell(s)/poly(ethylene vinyl acetate) sheet/polyester film;
- fluoropolymer film/HMF-PVB/solar cell(s)/poly(ethylene-co-methyl acrylate) sheet/polyester film;
- glass/poly(ethylene-co-butyl acrylate) sheet/solar cell(s)/HMF-PVB/barrier coated film/poly(ethylene-co-butyl acrylate) sheet/glass;
- thin film solar cell supported on a rigid sheet superstrate/HMF-PVB/rigid sheet;
- thin film solar cell supported on a glass sheet superstrate/HMF-PVB/glass sheet;
and the like, wherein the term "HMF-PVB" denotes the high melt flow poly(vinyl butyral) sheet described above. In addition, besides the Tedlar® film from DuPont, suitable fluoropolymer films also include fluoropolymer/polyester/fluoropolymer multilayer films (e.g., Tedlar®/PET/Tedlar® or TPT laminate film available from Isovolta AG., Austria or Madico, Woburn, MA).

Any lamination process known within the art (such as an autoclave or a non-autoclave process) may be used to prepare the solar cell modules.

In an exemplary process, the component layers of the solar cell module are stacked in the desired order to form a pre-lamination assembly. The assembly is then placed into a bag capable of sustaining a vacuum ("a vacuum bag"), the air is drawn out of the bag by a vacuum line or other means, the bag is sealed while the vacuum is maintained (e.g., at least 27-28 in Hg (689-711 mm Hg)), and the sealed bag is placed in an autoclave at a pressure of 150 to 250 psi (11.3 to 18.8 bar), a temperature of 130°C to 180°C, or 120°C to 160°C, or 135°C to 160°C, or 145°C to 155°C, for 10 to 50 min, or 20 to 45 min, or 20 to 40 min, or 25 to 35 min. A vacuum ring may be substituted for the vacuum bag. One type of suitable vacuum bag is disclosed within U.S. Patent No. 3,311,517. Following the heat and pressure cycle, the air in the autoclave is cooled without adding additional gas to maintain pressure in the autoclave. After about 20 min of cooling, the excess air pressure is vented and the laminates are removed from the autoclave.

Alternatively, the pre-lamination assembly may be heated in an oven at 80°C to 120°C, or 90°C to 100°C, for 20 to 40 min, and thereafter, the heated assembly is passed through a set of nip rolls so that the air in the void spaces between the individual layers may be squeezed out, and the edge of the assembly sealed. The assembly at this stage is referred to as a pre-press.

The pre-press may then be placed in an air autoclave where the temperature is raised to 120°C to 160°C, or 135°C to 160°C, at a pressure of 100 to 300 psi (6.9 to 20.7 bar), or preferably 200 psi (13.8 bar). These conditions are maintained for 15 to 60 min, or 20 to 50 min, and after which, the air is cooled while no more air is added to the autoclave. After 20 to 40 min of cooling, the excess air pressure is vented and the laminated products are removed from the autoclave.

The solar cell modules may also be produced through non-autoclave processes. Such non-autoclave processes are disclosed, e.g., in U.S. Patent Nos. 3,234,062; 3,852,136; 4,341,576; 4,385,951; 4,398,979; 5,536,347; 5,853,516; 6,342,116; and 5,415,909, U.S. Patent Publication No. 20040182493, European Patent No. EP1235683 B1, and PCT Patent Publication Nos. WO9101880 and WO03057478. Generally, the non-autoclave processes include heating the pre-lamination assembly and the application of vacuum, pressure or both. For example, the assembly may be successively passed through heating ovens and nip rolls.

These examples of lamination processes are not intended to be limiting. Essentially any lamination process may be used.

If desired, the edges of the solar cell module may be sealed to reduce moisture and air intrusion and the potential degradative effect on the efficiency and lifetime of the solar cell(s) by any means disclosed within the art. Suitable edge seal materials include, but are not limited to, butyl rubber, polysulfide, silicone, polyurethane, polypropylene elastomers, polystyrene elastomers, block copolymer elastomers, styrene-ethylene-butylene-styrene (SEBS), and the like.

The invention is further illustrated in the following examples of certain embodiments.

### EXAMPLES

The following Examples are intended to be illustrative of the invention, and are not intended in any way to limit the scope of the invention.

### Comparative Examples CE1-2 and Examples E1-2.

In each of the comparative examples CE1-2 and examples E1-2, a 12x12 inch (305x305 mm) laminate structure consisted of, in order of position from the top to the bottom side, a top glass sheet, a bi-axially oriented poly(ethylene terephthalate) film shim, a a poly(vinyl butyral) sheet with various MFR levels, and a bottom glass sheet was prepared and subjected to bake tests. In such laminate structures, the film shims were included to mimic the solar cells and/or solar cell wirings and the bake test results demonstrated how well the poly(vinyl butyral) sheets laminates to the top glass sheets with the film shims in between.

Specifically, to prepare the laminates, the 305x305x2.6 mm float glass sheets were washed with a solution of trisodium phosphate (5 g/l) in de-ionized water at 50°C for 5 min, rinsed thoroughly with de-ionized water for 5 minutes and dried. Then, over the center of the bottom glass sheet, was placed a 5 mm wide, 12 in (305 mm) long, and 2 mil (0.05 mm) thick bi-axially oriented poly(ethylene terephthalate) film shim, a 30 mil (0.76 mm) thick poly(vinyl butyral) sheet, and then a top glass sheet. The MFR level for each of the poly(vinyl butyral) sheets was determined in accordance to ASTM Test Method 1238 (at 150°C using a 5 kg load and a 2 mm orifice). Results are reported in Table 1. In addition, the poly(vinyl butyral) interlayer sheet used in E1 was further tested in accordance to ASTM Test Method 1238 at 150°C using a 2.26 kg load. Its MFR as determined under such condition was 0.3 g/10 min. The laminate was then prepared by a nip roll process as follows. Specifically, the pre-lamination assemblies, as obtained above, were first placed in a forced air oven at 105°C for 20 minutes and then passed through a set of nip rolls with a nip roll gap set at 4.3 mm. After being passed through the nip rolls, the assemblies were further placed into an air autoclave and the temperature and pressure were increased from ambient to 135°C at 13.8 bar over 15 min. This temperature and pressure was maintained for 30 min and the autoclave was then cooled by cooling the air while no more air was added to the autoclave. After 20 min of cooling (or when the air temperature reaches less than 50°C), the excess pressure was vented and the final laminate was removed from the autoclave.

In the bake tests, each of the laminates was placed in a forced air oven at a temperature of 105°C for 2 hours, and the total number of bubbles formed in the laminate was then counted. Results were as tabulated in Table 1. The laminate was then returned to the oven and maintained at a temperature of 120°C for 2 hours. After this time, the total number of bubbles was again counted. Results were as tabulated in Table 1. The laminate was again returned to the oven and maintained at a temperature of 135°C for 2 hours. The total number of bubbles was then counted. Results were as tabulated in Table 1. The laminate was returned to the oven and maintained at a temperature of 150°C for 2 additional hours. The total number of bubbles was then counted. Results were as tabulated in Table 1.

**TABLE 1**

| Example | MFR (g/10 min) | Bake Test (Number of Bubbles) | | | |
|---|---|---|---|---|---|
| | | 105°C | 120°C | 135°C | 150°C |
| CE 1 | < 0.7 | 0 | 8 | 16 | 32 |
| CE 2 | 0.7 | 0 | 4 | 5 | 9 |
| E1 | 1.14 | 0 | 0 | 0 | 5 |
| E2 | 1.25 | 0 | 0 | 3 | 3 |

The results demonstrate that fewer bubbles were formed in laminates (E1 and E2) comprising poly(vinyl butyral) sheets with high MFR (above 0.8 g/10 min) and a greater number of bubbles were formed in laminates (CE1 and CE2) comprising poly(vinyl butyral) sheets with lower MFR (less than 0.8 g/10 min). Also, it was found that, in CE1 and CE2, the bubbles formed along both the film shim and the trailing edge during the nip roll stage of the lamination process while in E1 and E2, the bubbles appeared only along the film shim.

### Examples E3-22:

### Lamination Process 1:

The component layers of the module structure are stacked to form a pre-lamination assembly. For the assembly containing a polymeric film layer as the outer surface layer, a cover glass sheet is placed over the film layer. The pre-lamination assembly is then placed within a Meier ICOLAM® 10/08 laminator (Meier laminator; Meier Vakuumtechnik GmbH, Bocholt, Germany). The lamination cycle includes an evacuation step (vacuum of 3 in Hg (76 mm Hg)) of 5.5 min and a pressing stage (pressure of 1000 mbar) of 5.5 min at a temperature of 145°C. The resulting laminate is then removed from the laminator.

### Lamination Process 2:

The component layers of the module structure are stacked to form a pre-lamination assembly. For the assembly containing a polymeric film layer as the outer surface layer, a cover glass sheet is placed over the film layer. The pre-lamination assembly is then placed within a vacuum bag, which is sealed and a vacuum is applied to remove the air from the vacuum bag. The bag is placed into an oven and heated to about 90°C to about 100°C for 30 min to remove any air contained between the assembly layers. The assembly is then subjected to autoclaving at 140°C for 30 min in an air autoclave at a pressure of 200 psig (14.3 bar). The air is cooled and no further air is added to the autoclave. After 20 min of cooling and when the air temperature reaches less than about 50°C, the excess pressure is vented and the vacuum bag containing the laminated assembly is removed from the autoclave. The resulting laminate is then removed from the vacuum bag.

12x12 in (305x305 mm) solar cell modules described below in Table 2 are assembled and laminated by either Lamination Process 1 (E3-12) or Lamination Process 2 (E13-22). Layers 1 and 2 constitute the incident layer and the front-sheet encapsulant layer, respectively, and Layers 4 and 5 constitute the back-sheet encapsulant layer and the backing layer, respectively, where applicable.

**TABLE 2**

| **Example No.** | **Solar Cell Laminate Structure** | | | | |
|---|---|---|---|---|---|
| | **Layer 1** | **Layer 2** | **Layer 3** | **Layer 4** | **Layer 5** |
| E3, 13 | Glass 1 | PVB 1 | Solar Cell 1 | | |
| E4, 14 | Glass 2 | PVB 2 | Solar Cell 2 | | |
| E5, 15 | | | Solar Cell 3 | PVB 3 | Glass 2 |
| E6, 16 | Glass 1 | PVB 2 | Solar Cell 4 | ACR 1 | FPF |
| E7, 17 | | | Solar Cell 5 | PVB 4 | Glass 2 |
| E8, 18 | Glass 1 | PVB 1 | Solar Cell 4 | PVB 2 | Glass 3 |
| E9, 19 | Glass 1 | PVB 1 | Solar Cell 2 | | |
| E10, 20 | | | Solar Cell 5 | PVB 2 | Glass 2 |
| E11, 21 | | | Solar Cell 5 | PVB 3 | Glass 2 |
| E12, 22 | Glass 1 | PVB 3 | Solar Cell 4 | PVB 3 | FPF |

| | | | | | |
|---|---|---|---|---|---|
| • ACR 1 is a 20 mil (0.51 mm) thick embossed sheet made of poly(ethylene-co-methacrylic acid) containing 18 wt% of polymerized residues of methacrylic acid and having a MI of 2.5 g/10 min (190°C, ISO 1133, ASTM D1238). • FPF is a 1.5 mil (0.038 mm) thick corona surface treated Tedlar® film from DuPont. • Glass 1 is Starphire® glass from PPG Industries. • Glass 2 is a 2.5 mm thick clear annealed float glass plate. • Glass 3 in a 3.0 mm thick Solex® solar control glass from PPG Industries. • PVB 1 is a 15 mil (0.38 mm) thick embossed sheet made from a plasticized poly(vinyl butyral) with a MFR of 1.1 g/10 min (ASTM 1238; 150°C, 5 kg, 2 mm orifice). • PVB 2 is a 20 mil (0.51 mm) thick embossed sheet made from a plasticized poly(vinyl butyral) with a MFR of 1.2 g/10 min (ASTM 1238; 150°C, 5 kg, 2 mm orifice). • PVB 3 is a 30 mil (0.76 mm) thick embossed sheet made from a plasticized poly(vinyl butyral) with a MFR of 1.25 g/10 min (ASTM 1238; 150°C, 5 kg, 2 mm orifice). • PVB 4 is a 45 mil (1.14 mm) thick embossed sheet made from a plasticized poly(vinyl butyral) with a MFR of 1.15 g/10 min (ASTM 1238; 150°C, 5 kg, 2 mm orifice). • Solar Cell 1 is a 10x10 in (254x254 mm) a-Si based thin film solar cell with a 125 µm thick stainless steel substrate (U.S. Patent No. 6,093,581, Example 1). • Solar Cell 2 is a 10x10 in (254x254 mm) CIS based thin film solar cell (U.S. Patent No. 6,353,042, column 6, line 19). • Solar Cell 3 is a 10x10 in (254x254 mm) CdTe based thin film solar cell (U.S. Patent No. 6,353,042, column 6, line 49). • Solar Cell 4 is a silicon solar cell made from a 10x10 in (254x254 mm) polycrystalline EFG-grown wafer (U.S. Patent No. 6,660,930, column 7, line 61). • Solar Cell 5 is a thin film solar cell supported on a 12x12 in (305x305 mm) glass sheet (U.S. Patent Nos. 5,512,107; 5,948,176; 5,994,163; 6,040,521; 6,137,048; and 6,258,620). | | | | | |

## Claims

1. A solar cell module comprising a solar cell layer and a poly(vinyl butyral) sheet, wherein (a) the solar cell layer comprises one or a plurality of electrically interconnected solar cells; (b) the solar cell layer has a light-receiving side and a non-light-receiving side; (c) the poly(vinyl butyral) sheet comprises a poly(vinyl butyral) resin and a plasticizer; and (d) the poly(vinyl butyral) sheet is laminated to one of the two sides of the solar cell layer, **characterised in that**
the poly(vinyl butyral) sheet has a melt flow rate (MFR) of 0.8 to 2 g/10 min as determined according to ASTM 1238 (150°C, 5 kg load, 2 mm orifice).

2. The solar cell module of claim 1, wherein the poly(vinyl butyral) sheet has a MFR of 1 to 1.7 g/10 min.

3. The solar cell module of claim 1 or 2, wherein the poly(vinyl butyral) sheet has a MFR of 1.1 to 1.3 g/10 min.

4. The solar cell module of any of claims 1-3, wherein the poly(vinyl butyral) sheet has a thickness of 0.25 to 1.52 mm.

5. The solar cell module of any of claims 1-4, wherein the poly(vinyl butyral) sheet has a thickness of 0.38 to 1.14 mm.

6. The solar cell module of any of claims 1-5, wherein the poly(vinyl butyral) resin has a weight average molecular weight of 30,000 to 600,000 and contains 12 to 23 wt% of hydroxyl groups calculated as polyvinyl alcohol (PVOH).

7. The solar cell module of any of claims 1-6, wherein the polyvinyl butyral) resin has a weight average molecular weight of 200,000 to 300,000 and contains 15 to 19 wt% of hydroxyl groups calculated as polyvinyl alcohol (PVOH).

8. The solar cell module of any of claims 1-7, wherein the poly(vinyl butyral) sheet comprises 5 to 80 parts per hundred (pph) of the plasticizer based on the dry weight of the poly(vinyl butyral) resin.

9. The solar cell module of any of claims 1-8, wherein the poly(vinyl butyral) sheet is directly laminated to the solar cell layer.

10. The solar cell module of any of claims 1-9, further comprising an incident layer (10) and/or a backing layer (18), wherein the incident layer is an outermost surface layer of the module and is positioned on the light-receiving side of the solar cell layer (14, 14a, 14b), and wherein the backing layer (18) is an outermost surface layer of the module and is positioned on the non-light receiving side of the solar cell layer (14, 14a, 14b).

11. The solar cell module of any of claims 1-10, wherein the solar cells are wafer-based solar cells selected from the group consisting of crystalline silicon (c-Si) and multi-crystalline silicone (mc-Si) based solar cells.

12. The solar cell module of any of claims 1-10, wherein the solar cells are thin film solar cells selected from the group consisting of amorphous silicon (a-Si), microcrystalline silicon (µc-Si), cadmium telluride (CdTe), copper indium selenide (CIS), copper indium/gallium diselenide (CIGS), light absorbing dyes, and organic semiconductors based solar cells.

13. A process for preparing a solar cell module, comprising: (i) providing an assembly comprising all the component layers recited in any of claims 1-12 and (ii) laminating the assembly to form the solar cell module.

14. The process of claim 13, wherein the laminating step is conducted by subjecting the assembly to heat and optionally vacuum or pressure.

## Patentansprüche

1. Ein Solarzellenmodul, umfassend eine Solarzellenschicht und ein Poly(vinylbutyral)-Flächengebilde, wobei (a) die Solarzellenschicht eine oder mehrere elektrisch miteinander verbundene Solarzellen umfasst, (b) die Solarzellenschicht eine lichtempfangende Seite und eine nicht lichtempfangende Seite besitzt, (c) das Poly(vinylbutyral)-Flächengebilde ein Poly(vinylbutyral)harz und ein Plastifizierungsmittel umfasst, und (d) das Poly(vinylbutyral)-Flächengebilde an eine der beiden Seiten der Solarzellenschicht laminiert ist, **dadurch gekennzeichnet, dass** das Poly(vinylbutyral)-Flächengebilde einen Schmelzindex (MFR) von 0,8 bis 2 g/10 min besitzt, ermittelt gemäß ASTM 1238 (150°C, 5 kg Masse, 2-mm-Düse).

2. Das Solarzellenmodul nach Anspruch 1, wobei das Poly(vinylbutyral)-Flächengebilde einen MFR von 1 bis 1,7 g/10 min besitzt.

3. Das Solarzellenmodul nach Anspruch 1 oder 2, wobei das Poly(vinylbutyral)-Flächengebilde einen MFR von 1,1 bis 1,3 g/10 min besitzt.

4. Das Solarzellenmodul nach einem der Ansprüche 1-3, wobei das Poly(vinylbutyral)-Flächengebilde eine Dicke von 0,25 bis 1,52 mm besitzt.

5. Das Solarzellenmodul nach einem der Ansprüche 1-4, wobei das Poly(vinylbutyral)-Flächengebilde eine Dicke von 0,38 bis 1,14 mm besitzt.

6. Das Solarzellenmodul nach einem der Ansprüche 1-5, wobei das Poly(vinylbutyral)harz ein Massenmittel der Molmasse von 30000 bis 600000 besitzt und 12 bis 23 Gew.-% Hydroxylgruppen enthält, berechnet als Polyvinylalkohol (PVOH).

7. Das Solarzellenmodul nach einem der Ansprüche 1-6, wobei das Poly(vinylbutyral)harz ein Massenmittel der Molmasse von 200000 bis 300000 besitzt und 15 bis 19 Gew.-% Hydroxylgruppen enthält, berechnet als Polyvinylalkohol (PVOH).

8. Das Solarzellenmodul nach einem der Ansprüche 1-7, wobei das Poly(vinylbutyral)-Flächengebilde 5 bis 80 Teile pro hundert Teilen (pph) des Plastifizierungsmittels umfasst, bezogen auf das Trockengewicht des Poly(vinylbutyral)harzes.

9. Das Solarzellenmodul nach einem der Ansprüche 1-8, wobei das Poly(vinylbutyral)-Flächengebilde direkt auf die Solarzellenschicht laminiert ist.

10. Das Solarzellenmodul nach einem der Ansprüche 1-9, ferner umfassend eine Auftreffschicht (10) und/oder eine Trägerschicht (18), wobei die Auftreffschicht eine äußerste Oberflächenschicht des Moduls ist und sich auf der lichtempfangenden Seite der Solarzellenschicht (14, 14a, 14b) befindet, und
wobei die Trägerschicht (18) eine äußerste Oberflächenschicht des Moduls ist und sich auf der nicht lichtempfangenden Seite der Solarzellenschicht (14, 14a, 14b) befindet.

11. Das Solarzellenmodul nach einem der Ansprüche 1-10, wobei die Solarzellen Wafer-basierte Solarzellen sind, ausgewählt aus der Gruppe bestehend aus auf kristallinem Silizium (c-Si) und multikristallinem Silizium (mc-Si) basierenden Solarzellen.

12. Das Solarzellenmodul nach einem der Ansprüche 1-10, wobei die Solarzellen Dünnschicht-Solarzellen sind, ausgewählt aus der Gruppe bestehend aus auf amorphem Silizium (a-Si), mikrokristallinem Silizium (µc-Si), Cadmiumtellurid (CdTe), Kupfer-Indium-Selenid (CIS), Kupfer-Indium-Gallium-Diselenid (CIGS), lichtabsorbierenden Farbstoffen und organischen Halbleitern basierenden Solarzellen.

13. Ein Verfahren zur Herstellung eines Solarzellenmoduls, umfassend: (i) Bereitstellen einer Zusammenstellung, die sämtliche der in einem der Ansprüche 1-12 genannten Komponentenschichten umfasst, und (ii) Laminieren der Zusammenstellung, um das Solarzellenmodul zu bilden.

14. Das Verfahren nach Anspruch 13, wobei der Laminierschritt dadurch erfolgt, dass die Zusammenstellung Wärme und gegebenenfalls Vakuum oder Druck ausgesetzt wird.

## Revendications

1. Module de cellule solaire comprenant une couche de cellule solaire et une feuille de poly(butyral de vinyle), dans lequel (a) la couche de cellule solaire comprend une ou plusieurs cellules solaires interconnectées électriquement ; (b) la couche de cellule solaire a un côté récepteur de lumière et un côté non récepteur de lumière ; (c) la feuille de poly(butyral de vinyle) comprend une résine de poly(butyral de vinyle) et un plastifiant ; et (d) la feuille de poly(butyral de vinyle) est stratifiée sur l'un des deux côtés de la couche de cellule solaire, **caractérisé en ce que** la feuille de poly(butyral de vinyle) a un indice de fluidité (MFR) de 0,8 à 2 g/10 min tel que déterminé selon la norme ASTM 1238 (150 °C, charge de 5 kg, orifice de 2 mm).

2. Module de cellule solaire selon la revendication 1, dans lequel la feuille de poly(butyral de vinyle) a un MFR de 1 à 1,7 g/10 min.

3. Module de cellule solaire selon la revendication 1 ou 2, dans lequel la feuille de poly(butyral de vinyle) a un MFR de 1,1 à 1,3 g/10 min.

4. Module de cellule solaire selon les revendications 1 à 3, dans lequel la feuille de poly(butyral de vinyle) a une épaisseur de 0,25 à 1,52 mm.

5. Module de cellule solaire selon l'une quelconque des revendications 1 à 4, dans lequel la feuille de poly(butyral de vinyle) a une épaisseur de 0,38 à 1,14 mm.

6. Module de cellule solaire selon l'une quelconque des revendications 1 à 5, dans lequel la résine de poly(butyral de vinyle) a un poids moléculaire moyen pondéral de 30 000 à 600 000 et contient de 12 à 23 % en poids de groupes hydroxyles calculés en tant qu'alcool polyvinylique (PVOH).

7. Module de cellule solaire selon l'une quelconque des revendications 1 à 6, dans lequel la résine de poly(butyral de vinyle) a un poids moléculaire moyen pondéral de 200 000 à 300 000 et contient de 15 à 19 % en poids de groupes hydroxyles calculés en tant qu'alcool polyvinylique (PVOH).

8. Module de cellule solaire selon l'une quelconque des revendications 1 à 7, dans lequel la feuille de poly(butyral de vinyle) comprend de 5 à 80 parties pour cent parties (pph) du plastifiant sur la base du poids sec de la résine de poly(butyral de vinyle) .

9. Module de cellule solaire selon l'une quelconque des revendications 1 à 8, dans lequel la feuille de poly(butyral de vinyle) est stratifiée directement sur la couche de cellule solaire.

10. Module de cellule solaire selon l'une quelconque des revendications 1 à 9, comprenant en outre une couche incidente (10) et/ou une couche de support (18), dans lequel la couche incidente est une couche de surface la plus externe du module positionnée sur le côté récepteur de lumière de la couche de cellule solaire (14, 14a, 14b), et
dans lequel la couche de support (18) est une couche de surface la plus externe du module positionnée sur le côté non récepteur de lumière de la couche de cellule solaire (14, 14a, 14b).

11. Module de cellule solaire selon l'une quelconque des revendications 1 à 10, dans lequel les cellules solaires sont des cellules solaires à base de tranches sélectionnées dans le groupe consistant en cellules solaires à base de silicium cristallin (c-Si) et à base de silicium multi-cristallin (mc-Si).

12. Module de cellule solaire selon l'une quelconque des revendications 1 à 10, dans lequel les cellules solaires sont des cellules solaires à couches minces sélectionnées dans le groupe consistant en cellules solaires à base de silicium amorphe (a-Si), de silicium microcristallin (µc-Si), de tellurure de cadmium (CdTe), de séléniure de cuivre et d'indium (CIS), de diséléniure de cuivre, d'indium et de gallium (CIGS), de teintures absorbant la lumière, et de semi-conducteurs organiques.

13. Processus de préparation d'un module de cellule solaire, comprenant : (i) la fourniture d'un ensemble comprenant toutes les couches constitutives selon l'une quelconque des revendications 1 à 12 et (ii) la stratification de l'ensemble pour former le module de cellule solaire.

14. Processus selon la revendication 13, dans lequel l'étape de stratification est réalisée en soumettant l'ensemble à la chaleur et facultativement à un vide ou à une pression.
